# EUROPEAN PATENT APPLICATION

(11) **EP 1 843 392 A1**
(43) Date of publication of application: **10.10.2007**
(21) Application number: 07075214.2
(22) Date of filing: 20.03.2007
(51) Int. Cl.: H01L 23/473

(54) **Electronics assembly having heat sink substrate disposed in cooling vessel**

(30) Priority: 05.04.2006 US 398344
(71) Applicant: Delphi Technologies, Inc., Troy, Michigan 48007 (US)
(72) Inventor: Ruiz, Javier, Noblesville, IN 46060 (US)
(74) Representative: Denton, Michael John

(57) **Abstract**

An electronics assembly (10) is provided having a housing (12) including walls defining a fluid vessel. One or more thermally conductive heat sink devices (20) extend through one or more openings (40) in the housing (12) and in thermal communication with a liquid coolant. One or more electronics devices (30) are mounted onto a mounting surface (22) of the heat sink devices (20) such that the electronics devices (30) are cooled by the liquid coolant in the fluid vessel.

## Description

### Technical Field

The present invention generally relates to electronics assemblies and, more particularly, relates to an electronics assembly having a cooling fluid passing through a vessel to cool electronics device(s).

### Background of the Invention

Power electronics devices typically employ electronics packages (devices) that generally contain electrical circuitry for conducting electrical current which, in turn, generates thermal energy (i.e., heat). Automotive high-power electronics, such as those employed in electric and hybrid-electric vehicles typically generate a significant amount of thermal energy during operation. Excessive heat build-up may cause reduced performance including electrical circuit failure. Thus, thermal energy must be dissipated and transferred away from the electronics to ensure proper operation of the device. Additionally, the power capability of the electronics package(s) and size of the electronics assembly generally depend upon the amount of heat dissipation that may be achieved.

For very high-power applications, such as electronics packages used in hybrid-electric or electric vehicles, enhanced cooling of electronics may be required. U.S. Patent No. 6,639,798 discloses an automotive electronics heat exchanger employing a heat sink device having a metal housing fluid vessel in fluid communication with an automotive radiator. The fluid vessel of the heat sink device is positioned in thermal communication with electronics power device(s) such that fluid coolant flows through the fluid vessel to cool the electronics package. The entire disclosure of U.S. Patent No. 6,639,798 is hereby incorporated herein by reference.

In the aforementioned assembly, an electronics power device, such as an integrated circuit (IC) package, is mounted on a circuit board via wave soldering. The board and power device are generally arranged such that the power device is disposed on an intermediate thermal interface material, such as a thermal adhesive strip. The thermal interface material, in turn, is positioned on the outside surface of the metal fluid vessel. Additionally, a clamp is further employed to ensure proper thermal conductivity by pressing the fluid vessel towards the electronics device. Thermal energy generated by the electronics power device is conducted through the thermal interface material to the outer surface of the metal housing of the fluid vessel, where the fluid coolant exchanges the thermal energy.

The resulting cooling achieved in the conventional electronics assemblies typically involves conducting thermal energy through several layers of thermal interface material. Each layer of thermal interface material generally adds more thermal resistance to the thermal conduction path. In some assembles, the thermal conduction path from the heat generating electronics device to the cooling fluid includes sections with low thermal conductivity, such as thermal grease or thermal conductive adhesives. This generally causes thermal losses in the power electronics stack which results in less effective cooling. The power stack in a typical assembly is generally defined as the material layers between the power electronics substrate (die) and the cooling fluid, which may include the die, solder, direct bond copper, aluminum nitride (AlN), thermal interface material, and metal heat sink vessel with fluid coolant.

It is therefore desirable to provide for an enhanced electronics assembly that minimizes thermal resistance in the power stack for electronics device(s) in thermal communication with a heat sink cooling fluid. In particular, it is desirable to minimize thermal resistance experienced between electronics device(s) and the heat sink cooling fluid to achieve a cost affordable and enhanced cooling of the electronics, such as those employed in high-power electronics packages on an automotive vehicle.

### Summary of the Invention

In accordance with the teaching of the present invention, an electronics assembly is provided offering fluid cooling of electronics device(s), such as to experience minimal thermal resistance. According to one aspect, the electronics assembly includes a housing having walls defining a fluid vessel. The housing has an inlet and an outlet and at least one opening in a wall. The assembly also includes a thermally conductive heat sink device extending through the at least one opening in the wall of the housing and sealed to the housing. The heat sink device has an electronics mounting surface and a heat exchange surface in thermal communication with cooling fluid in the fluid vessel. The assembly further includes an electronics device mounted onto the electronics mounting surface of the heat sink device such that the electronics device is cooled by the cooling fluid exchanging thermal energy at the heat exchange surface. According to a further aspect, the cooling fluid is a liquid coolant.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
FIG. 1 is a perspective view of an electronics assembly employing fluid cooling according to one embodiment of the present invention;
FIG. 2 is an exploded view of the electronics assembly shown in FIG. 1;
FIG. 3 is a partial exploded view of the assembly further illustrating heat sink substrates aligned inside the fluid vessel;
FIG. 4 is a perspective view of a single heat sink substrate and electronic devices mounted thereto; and
FIG. 5 is a cross-sectional view of the electronics assembly taken through line V-V in FIG. 1.

### Description of the Preferred Embodiments

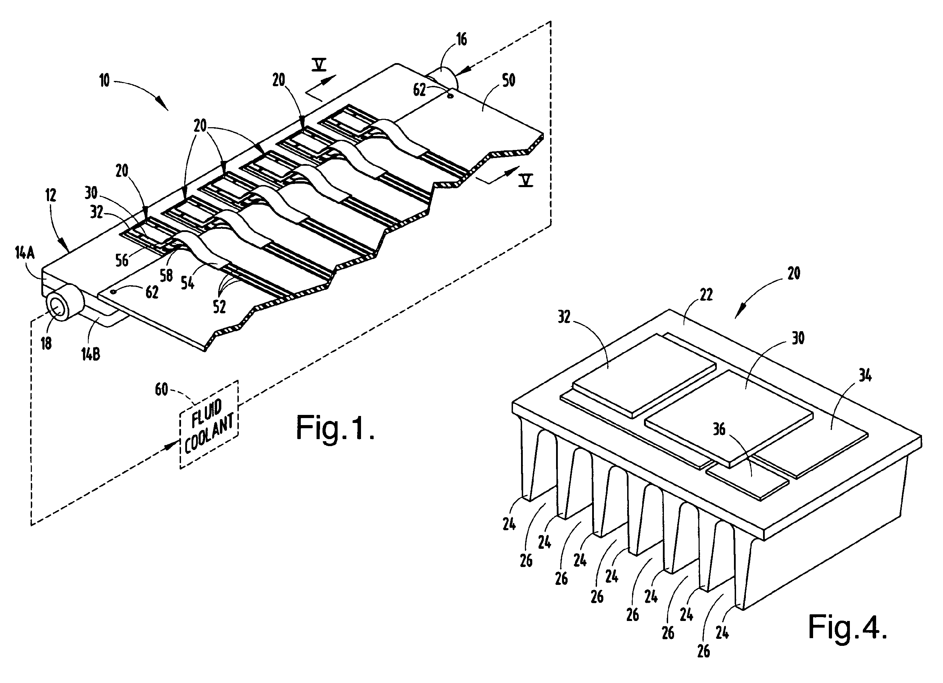

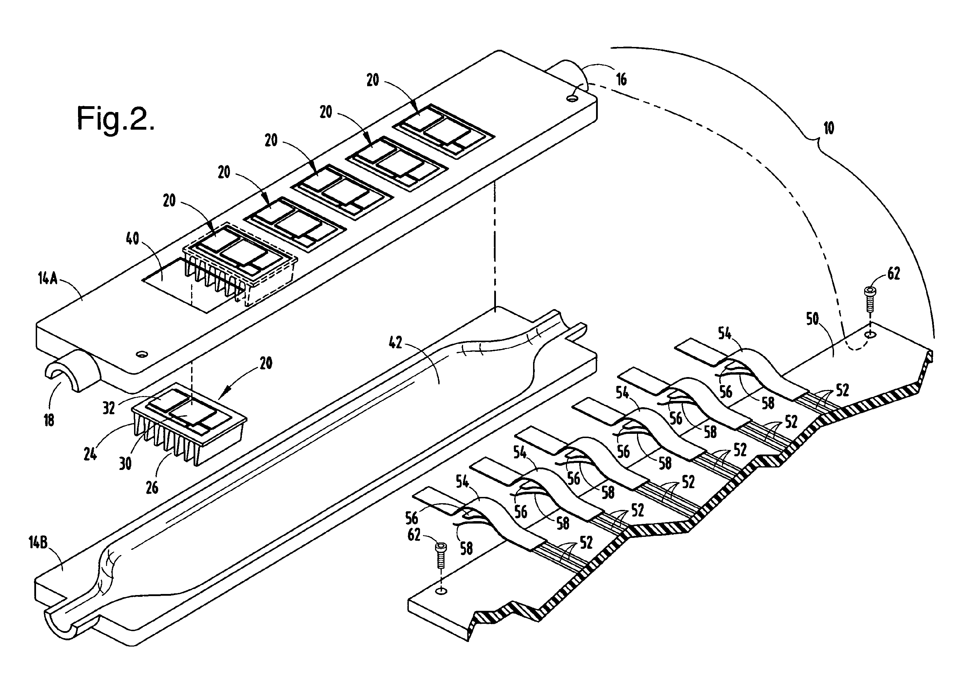

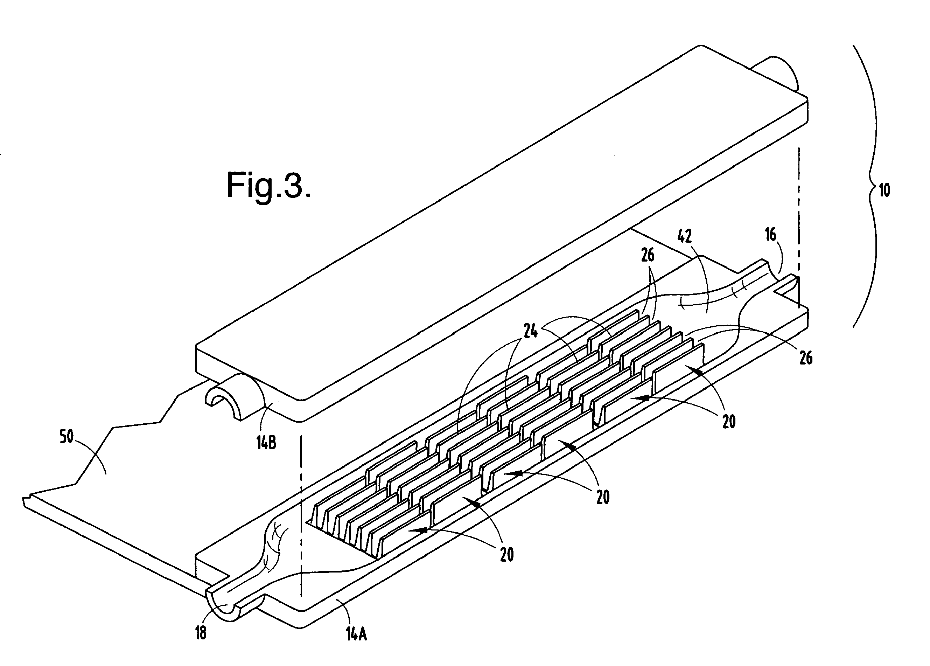

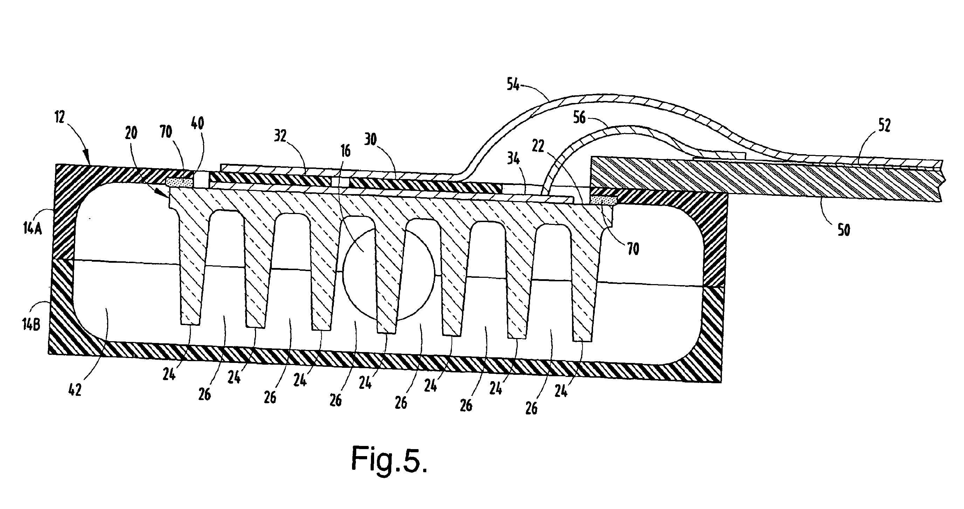

Referring to FIGS. 1-5, an electronics assembly 10 is generally illustrated according to one embodiment of the present invention. The electronics assembly 10 includes thermal conductive heat sink devices 20 assembled to a fluid vessel housing 12. Mounted on each heat sink device 20 are first and second electronics devices 30 and 32. The assembly 10 efficiently and effectively cools the electronics devices 30 and 32 with cooling fluid (e.g., liquid) 60 passing through the fluid vessel 12 to exchange thermal energy (heat) and dissipate the heat away from the electronics devices 30 and 32.

The electronics assembly 10 employs a fluid cooled heat exchange device 12 in the form of a housing defining a fluid vessel that passes fluid coolant, such as liquid coolant, according to the embodiment shown. The liquid coolant may include water and/or antifreeze liquid. The fluid vessel 12 includes first and second housing members 14A and 14B generally having walls that define a sealed fluid vessel 12. Housing members 14A and 14B are sealingly engaged together, such as via an adhesive, to prevent leakage of fluid coolant from within the fluid vessel housing 12. According to one embodiment, the fluid vessel 12 is made of a polymeric (plastic) material. The polymeric material provides thermal insulation and dielectric properties to the fluid vessel 12.

The fluid vessel 12 is formed having an inlet port 16 for receiving liquid coolant, and an outlet port 18 for exiting the liquid coolant. The inlet port 16 and outlet port 18 may include hose barb fluid fittings integrally formed into housing members 14A and 14B to facilitate easy connection to a hose to receive fluid coolant from a fluid coolant source 60. The fluid coolant passes from the coolant source 60, into inlet port 16, through the cooling vessel compartment 42, and out the outlet port 16. The fluid coolant may further pass through an exterior cooling radiator (not shown), such as an automotive vehicle radiator, to cool the fluid before returning to the fluid coolant source 16, and may employ a pump to excite the fluid flow.

Formed in a wall of the fluid vessel housing 12 are a plurality of openings 40. Each opening 40 is configured in size and shape to receive a thermally conductive heat sink device 20. In the embodiment shown, six rectangular openings 40 are shown receiving six thermally conductive heat sink devices 20. Each heat sink device 20 extends through the housing wall and is sealed to the housing wall. However, it should be appreciated that one or more openings 40 may be employed in a wall of the fluid vessel housing 12 to receive one or more heat sink devices 20, each heat sink device 20 having one or more electronics devices.

Each heat sink device 20 is formed of a thermally conductive dielectric substrate material, according to one embodiment. The heat sink device 20 may be formed of a ceramic material, such as aluminum nitride (AlN), according to one embodiment. According to another embodiment, the heat sink device 20 may be formed of silicon nitride (Si₃N₄). According to a further embodiment, the heat sink device is formed of a silicon carbide. Each heat sink device 20 is thermally conductive and may be electrically nonconductive (dielectric).

Each heat sink device 20 includes a substantially planar upper surface, referred to as an electronics mounting surface 22. According to one embodiment, surface 22 may include an outer titanium layer. One or more electronic devices 30 or 32 are mounted on top of the mounting surface 22. The heat sink devices 20 may be sealingly engaged to the housing 12 by an adhesive, such as an epoxy. In the embodiment shown, an adhesive 70 is applied between the perimeter on the mounting surface 22 and the inside surface of housing 12 such that the opening 40 is sealed closed.

The heat sink device 20 is further configured having a plurality of fins 24 that extend into the fluid compartment 42 of the vessel 12. Fins 24 are spaced to provide channels 26 formed therebetween for allowing fluid coolant to flow between fins 24 to exchange thermal energy. The fins 24 contact the fluid coolant and provide an increased area heat exchange surface to exchange thermal energy (heat) communicated from the electronics devices 30 and 32 with the fluid coolant. The arrangement of fins 24 on adjacent heat sink devices 20 are configured such that adjacent fins 24 on adjacent device 20 are offset from each other. The offset arrangement of the fins 24 on adjacent heat sink devices 20 serve to stir up fluid coolant flowing through the fluid vessel 12 as well as to multiple its internal wetted surface area to enhance the heat exchange.

The electronic devices 30 and 32 are shown according to an exemplary embodiment as isolated gate bipolar transistors (IGBTs) and diodes, respectively, mounted on the electronics mounting surface 22 of heat sink devices 20. More specifically, electronic devices 30 and 32 are formed on top of copper pads 34 and 36, which serve as electrical terminals engaging the bottom surface of electronic devices 30 and 32 to provide electrical conductivity as well as high thermal conductivity. According to one example, copper pad 34 serves as a source terminal, while copper pad 36 serves as a gate terminal. It should be appreciated that the top surface of electronic devices 30 and 32 form an electrical terminal, such as a drain terminal, according to one embodiment.

The copper pads 34 and 36 may be directly bonded onto the outer titanium layer of heat sink device 20. The electronic devices 30 and 32 may be connected onto the top surface of copper pads 34 and 36 via solder, conductive epoxy, or other adhesive. While the electronic devices 30 and 32 are shown connected onto the mounting surface 22 of heat sink device 20, it should be appreciated that electronic devices 30 and 32 may otherwise be connected onto the heat sink device 20 with or without the copper pads 34 and 36.

A printed circuit board 50 is further shown connected to the fluid cooling vessel 12 via fasteners 62 (e.g., screws), according to one embodiment. The circuit board 50 may include a substrate made of a low temperature co-fired ceramic (LTCC), an organic material such as FR4, a metal such as stainless steel or any other suitable material. The circuit board 50 may have electrical circuitry formed on the top side surface and/or bottom side surface, as well as between laminated intermediate layers of the circuit board 50. In the embodiment shown, circuit board 50 has electrical circuitry 52 formed on the top surface of the circuit board 50 for transmitting electrical current.

The electronics devices 30 and 32 are further coupled to electrical circuitry 52 on circuit board 50 via ribbon bonds 54 and 56 and wire bond 58. Alternately, wire bonds and ribbon bonds may be employed in place of each other. Ribbon bonds 54 and 56 and wire bond 58 are electrically conductive circuit interconnections that may be made of aluminum or other electrically conductive material, such as aluminum traces. According to the ribbon bond embodiment, ribbon bond 54 contacts the top surface of electronics devices 30 and 32 to provide the source terminal electrical connection, while bottom ribbon bond 56 contacts the drain 34 terminal. Wire bond 58 contacts the gate 36 terminal. The opposite ends of ribbon bonds 54 and 56 and wire bond 58, in turn, are connected to the appropriate circuitry 52 on circuit board 50 to complete the electrical circuit interconnection. While ribbon bonds 54 and 56 and wire bond 58 are shown and described herein, it should be appreciated that other electrical connections may be employed to connect the electronics devices 30 and 32 to electrical circuitry 52 on the circuit board 50, such as soldered lead frames or off hanging leads.

According to the present invention one or more electronics devices are assembled onto the heat sink devices 20. In the embodiment shown, each heat sink device 20 has two electronics devices 30 and 32 mounted on the top mounting surface 22 of the heat sink device 20. Each electronics device 30 and 32 has electrical circuitry and top and bottom sides that provide electrical terminals. The electronics devices 30 and 32 generate thermal energy (heat) when conducting electrical current during operation. The electronics devices 30 and 32 are generally shown connected onto heat sink devices 20 via copper pads 34 and 36. In the exemplary embodiment shown, electronics devices 30 and 32 are IGBT 30 and diode 32. Copper pads 34 and 36 provide electrical connections to the gate and source terminals and also provide high thermal conductivity between the electronics devices 30 and 32 and the heat sink devices 20. However, other electronics device configurations may be employed.

Any of a number of electronics devices 30 and 32 may be employed which may include one or more semiconductor devices, such as transistors configured to provide controlled switching operation, operate as a diode, provide voltage regulation, or perform other functions. The electronics devices 30 and 32 may be fabricated semiconductor chips, such as flip chips with solder bumps, wire bonded, or ribbon connections that are electrically and/or physically coupled to the heat sink substrate 20. Electronics devices 30 and 32 may also include resistors, capacitors, field effect transistors (FETS), isolated gate bipolar transistors (IGBTs), and other electrical devices. In a hybrid-electric or electric vehicle application, examples of the electronics device applications may include power inverters, DC-to-DC converters and DC-to-AC converters.

The electronics assembly 10 of the present invention employs heat exchange devices 20 disposed in direct thermal communication with the a fluid coolant and, more specifically, a liquid coolant, such as water and/or antifreeze solution. Each heat sink device 20 is shown disposed in close thermal communication with the underside surface of electronics devices 30 and 32. The opposite side of the heat sink devices 20 exchanges heat with the liquid coolant via the heat exchange surface of fins 24. The heat sink device 20 thereby operates to efficiently dissipate thermal energy (heat) away from the electronics devices 30 and 32 for purposes of cooling the corresponding electronics devices 30 and 32.

By enhancing the heat dissipation, particularly for high-powered electronics devices 30 and 32, the electronics assembly 10 advantageously may allow for the reduction in the number and/or size of electronics devices 30 and 32 used in the assembly 10, thereby reducing the size and cost of the overall assembly 10. Additionally, the enhanced heat dissipation achieved by employing the assembly 10 of the present invention may allow for an increase in the power output of the electronics devices 30 and 32, thereby improving the overall performance of the electronics assembly 10. These and other advantages may be achieved by the novel assembly and cooling design of the present invention.

It will be understood by those who practice the invention and those skilled in the art, that various modifications and improvements may be made to the invention without departing from the spirit of the disclosed concept. The scope of protection afforded is to be determined by the claims and by the breadth of interpretation allowed by law.

## Claims

1. An electronics assembly (10) comprising:
a housing (12) comprising walls defining a fluid vessel, an inlet and an outlet, said housing (12) further comprising at least one opening (40) formed in a wall;
a thermally conductive heat sink device (20) extending through said at least one opening (40) in said wall of the housing (12) and sealed to the housing (12), said heat sink device (20) comprising an electronics mounting surface (22), and a heat exchange surface (24) in thermal communication with cooling fluid in the fluid vessel; and
an electronics device (30) mounted onto the electronics mounting surface (22) of the heat sink device (20) such that the electronics device (30) is cooled by the cooling fluid exchanging thermal energy at the heat exchange surface (24).

2. The electronics assembly as defined in claim 1, wherein the heat sink device (20) comprises a thermally conductive dielectric material.

3. The electronics assembly as defined in claim 1, wherein the cooling fluid comprises liquid.

4. The electronics assembly as defined in claim 1 further comprising a circuit board (50) having electrical circuitry coupled to the electronics device (30).

5. The electronics assembly as defined in claim 4 further comprising an electrical interconnect (54) connecting the electronics device (30) to the electrical circuitry on the circuit board (50).

6. The electronics assembly as defined in claim 1, wherein the electronics assembly (10) comprises a plurality of heat sink devices (20) and a plurality of electronics devices (30 and 32) mounted on the plurality of heat sink devices (20), wherein each of the heat sink devices (20) comprises a plurality of fins (24), and wherein some of the fins (24) are offset from other of the fins (24) to disturb the flow of cooling fluid through the fluid vessel.

7. The electronics assembly as defined in claim 1 further comprising a plurality of electronics devices (30 and 32) mounted onto the heat sink device (20).

8. The electronics assembly as defined in claim 1, wherein the housing (12) comprises first and second members (14A and 14B).

9. The electronics assembly as defined in claim 1, wherein the heat sink device (20) comprises a ceramic material.

10. The electronics assembly as defined in claim 9, wherein the ceramic material comprises aluminum nitride.

11. The electronics assembly as defined in claim 1, wherein the housing (12) comprises a polymeric material.
